# EUROPÄISCHE PATENTSCHRIFT

(11) **EP 0 372 646 B1**
(45) Veröffentlichungstag und Bekanntmachung des Hinweises auf die Patenterteilung: **07.09.1994**
(21) Anmeldenummer: 89203066.9
(22) Anmeldetag: 04.12.1989
(51) Int. Cl.: H03H 9/08

(54) **Anordnung für einen Quarzoszillator**
Quartz oscillator arrangement
Dispositif pour oscillateur à quartz

(30) Priorität: 08.12.1988 DE 3841277
(43) Veröffentlichungstag der Anmeldung: 13.06.1990
(73) Patentinhaber: Philips Patentverwaltung GmbH, 22335 Hamburg (DE); Philips Electronics N.V., 5621 BA Eindhoven (NL)
(72) Erfinder: Schott, Helmut, D-8500 Nürnberg (DE); Schemmel, Hans-Robert, D-8500 Nürnberg (DE)
(74) Vertreter: Peuckert, Hermann, Dipl.-Ing.

(56) Entgegenhaltungen:
- EP-A- 0 142 826
- US-A- 2 938 099

## Beschreibung

Die Erfindung betrifft eine Anordnung für einen Quarzoszillator mit einem ersten in einem Thermostatgehäuse angeordneten Quarz, wobei im Thermostatgehäuse ein zweiter Quarz eines Hilfsoszillators angeordnet ist.

Derartige Anordnungen werden insbesondere für Taktversorgungseinrichtungen synchroner Daten- und Nachrichtennetze benötigt. Die dort verwendeten Oszillatoren sollen eine hohe Stabilität besitzen und sich mit Hilfe von Regelschaltungen auf externe Referenzfrequenzen synchronisieren lassen. Die geforderte Stabilität hat eine konstante Umgebungstemperatur für den frequenzbestimmenden Schwingquarz zur Voraussetzung, die in der Regel durch einen Thermostaten erreicht wird. Der Quarz wird dabei im Umkehrpunkt der Temperatur-Frequenzkennlinie betrieben, um Frequenzschwankungen klein zu halten.

Aus EP-A 142 826 ist eine Anordnung zur Stabilisierung der von einem Frequenzgenerator, insbesondere einem Quarzoszillator, abgegebenen Frequenz bekannt. Die Anordnung weist eine die frequenzbestimmenden Elemente auf einer vorgegebenen Temperatur haltende Thermostatanordnung auf, welche aus einem die frequenzbestimmenden Elemente aufnehmenden Thermostatgehäuse und einem die Innentemperatur dieses Thermostatgehäuses regelnden, ein Heizelement und einen Temperatursensor aufweisenden, Temperaturregler besteht. Der Temperaturregler weist als Temperatursensor einen temperaturabhängigen Hilfsoszillator auf, dessen frequenzbestimmende Elemente ebenfalls im Thermostatgehäuse aufgenommen sind und dessen Frequenz nach Maßgabe einer Bezugsfrequenz regelbar ist und die Stellgröße für die dem Thermostatgehäuse zuzuführende Heizleistung bildet. Der Quarzoszillator wird dabei im Umkehrpunkt der Temperatur-Frequenzkennlinie betriebenen, während die Temperaturabhängigkeit der Frequenz des Hilfsoszillators im interessierenden Temperaturbereich annähernd linear ist.

Der Erfindung liegt die Aufgabe zugrunde, eine Anordnung der eingangs genannten Art bei gleichzeitig einfachem Aufbau so zu verbessern, daß die Quarztemperatur und damit auch die Frequenz des Quarzoszillators höchst stabil und wertgenau einhaltbar ist.

Die Aufgabe wird bei einer Anordnung der eingangs genannten Art dadurch gelöst, daß das Thermostatgehäuse symmetrisch ausgebildet ist und zwei Kammern zur Aufnahme der Quarze des Quarzoszillators und des Hilfsoszillators aufweist, daß die Quarze des Quarzoszillators und des Hilfsoszillators mit jeweils identischen Quarzgehäusen versehen sind und daß die Frequenz des Hilfsoszillators der Frequenz des Quarzoszillators entspricht.

Vorteilhafte Ausgestaltungsformen sind in den Unteransprüchen enthalten.

Anhand des in den Figuren schematisch dargestellten Ausführungsbeispieles soll die Erfindung näher erläutert werden.

Fig. 1 zeigt eine Anordnung für einen Quarzoszillator in der Draufsicht.

Fig. 2 zeigt die Anordnung der Fig. 1 bezüglich einer Schnittlinie C - D.

Fig. 3 zeigt die Anordnung der Fig. 1 bezüglich einer Schnittlinie A - B.

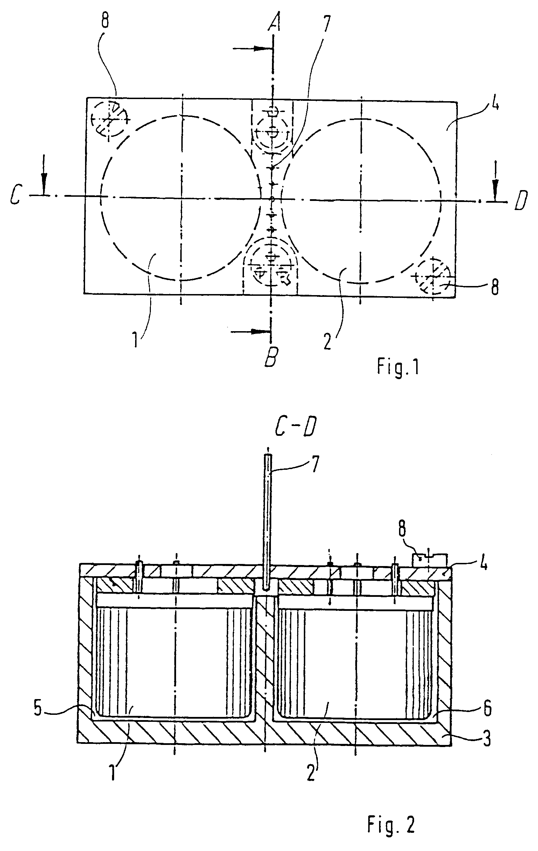

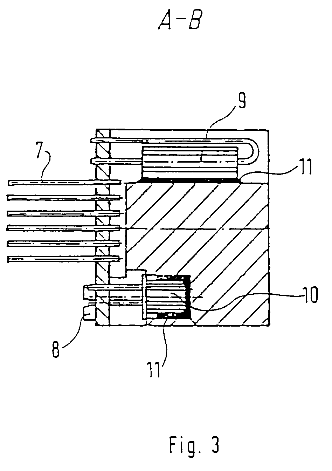

In den Figuren 1 bis 3 ist eine Anordnung zur Stabilisierung der Frequenz eines Quarzoszillators mit einem Thermostatgehäuse 3 dargestellt. Das Thermostatgehäuse weist zwei Kammern 5, 6 zur Aufnahme eines ersten Quarzes 1 des Quarzoszillators und eines zweiten Quarzes 2 eines Hilfsoszillators 2 auf. Der Quarz 1 des Quarzoszillators wird zur Verminderung von Frequenzschwankungen in bekannter Weise im Umkehrpunkt der Temperatur-Frequenzkennlinie betrieben. Der Hilfsoszillator 2 wird bei gleicher Frequenz betrieben, wobei die Frequenz des Hilfsoszillators 2 eine starke Temperaturabhängigkeit aufweist und so eine Regelgröße zur Stabilisierung der Temperatur liefert. Um möglichst identische Betriebsbedingungen des Quarzoszillators 1 und des Hilfsoszillators 2 sicherzustellen, sind die Quarze 1, 2 des Quarzoszillators und des Hilfsoszillators mit jeweils identischen Quarzgehäusen versehen.

Das Thermostatgehäuse 3 weist weiter eine Abdeckung 4 auf, die bei dem in den Figuren 1 bis 3 dargestellten Ausführungsbeispiel aus einer Leiterplatte mit Metallbeschichtung gebildet wird und mit Schrauben 8 an dem Thermostatgehäuse 3 befestigt ist. Die Leiterplatte 4 ist mit einem Transistor 10, einem Widerstand 9, mit Verbindungsleitungen 7 zum Herstellen der erforderlichen elektrischen Anschlüsse sowie mit weiteren durch die Quarzgehäuse hindurchgeführten Verbindungsleitungen zu den Quarzen 1, 2 versehen. Der Widerstand 9 und der Transistor 10 sind in entsprechenden Ausnehmungen angeordnet, die bei dem in den Figuren dargestellten Ausführungsbeispiel in das Thermostatgehäuse 3 eingefräst sind und mit diesem über eine wärmeleitende Masse 11 verbunden sind. Der Widerstand 9 und der Transistor 10 bilden die Heizelemente zur Erzeugung einer konstanten Temperatur in den beiden Kammern 5, 6 des Thermostatgehäuses 3. Die Verbindungsleitungen 7 bestehen bei einer bevorzugten Ausführungsform zur Verminderung der Wärmeabgabe aus einem Material mit geringer Wärmeleitfähigkeit.

Zur Erzielung gleicher Temperaturbedingungen ist das Thermostatgehäuse 3 symmetrisch ausgebildet. Daher sind der Widerstand 9, der Transistor 10 und die Verbindungsleitungen 7 ebenfalls symmetrisch in der Mitte des Thermostatgehäuses 1 angeordnet, so daß sie jeweils den gleichen Abstand zu den zwei Kammern 5, 6 aufweisen. Eine gleichmäßige Wärmeverteilung wird bei dem in den Figuren 1 bis 3 dargestellten Ausführungsbeispiel auch dadurch erreicht, daß das Thermostatgehäuse 3 aus Aluminium besteht.

Das Thermostatgehäuse 3 weist eine in den Figuren nicht dargestellte isolierende Ummantelung, z.B. aus Styropor, auf, wodurch eine weitere Stabilisierung der Temperatur im Innern des Thermostatgehäuses erreicht wird. Diese Ummantelung ist bei einer vorteilhaften Ausgestaltungsform von einem Kupfermantel und einer weiteren Ummantelung aus Styropor umgeben.

Durch die vorbeschriebenen Maßnahmen weisen die Quarze 1, 2 identische Aufheiz- und Abkühlbedingungen auf, wodurch die Quarztemperaturen der Quarze 1, 2 des Quarzoszillators und des Hilfsoszillators und damit auch die Frequenz des Quarzoszillators höchst stabil und wertgenau einhaltbar sind.

## Patentansprüche

1. Anordnung für einen Quarzoszillator mit einem ersten in einem Thermostatgehäuse (3) angeordneten Quarz (1), wobei im Thermostatgehäuse (3) ein zweiter Quarz (2) eines Hilfsoszillators (2) angeordnet ist,
dadurch gekennzeichnet,
daß das Thermostatgehäuse (3) symmetrisch ausgebildet ist und zwei Kammern (5, 6) zur Aufnahme der Quarze (1, 2) des Quarzoszillators (1) und des Hilfsoszillators (2) aufweist, daß die Quarze (1, 2) des Quarzoszillators und des Hilfsoszillators mit jeweils identischen Quarzgehäusen versehen sind und daß die Frequenz des Hilfsoszillators der Frequenz des Quarzoszillators entspricht.

2. Anordnung nach Anspruch 1,
dadurch gekennzeichnet,
daß das Thermostatgehäuse (3) Heizelemente (9, 10) aufweist, die jeweils im gleichen Abstand zu den zwei Kammern (5, 6) angeordnet sind.

3. Anordnung nach einem der Ansprüche 1 oder 2,
dadurch gekennzeichnet,
daß das Thermostatgehäuse (3) eine als Leiterplatte ausgebildete Abdeckung (4) zur Aufnahme elektrischer Anschlußleitungen (7) und der Heizelemente (9, 10) aufweist.

4. Anordnung nach einem der Ansprüche 1 bis 3,
dadurch gekennzeichnet,
daß die elektrischen Verbindungsleitungen (7) aus einem Material mit einer geringen Wärmeleitfähigkeit bestehen und in der Mitte des Thermostatgehäuses angeordnet sind.

5. Anordnung nach einem der Ansprüche 1 bis 4,
dadurch gekennzeichnet,
daß das Thermostatgehäuse (3) eine isolierende Ummantelung aufweist.

6. Anordnung nach einem der Ansprüche 1 bis 5,
dadurch gekennzeichnet,
daß das Thermostatgehäuse (3) aus Aluminium besteht.

## Claims

1. An arrangement for a quartz oscillator comprising a first quartz crystal (1) provided in an oven case (3), a second quartz crystal (2) of an auxiliary oscillator (2) also being provided in the oven case (3), characterized in that the oven case (3) is symmetrically constructed and comprises two chambers (5,6) for accommodating the quartz crystals (1,2) of the quartz oscillator (1) and auxiliary oscillator (2), in that the quartz crystals (1,2) of the quartz oscillator and auxiliary oscillator are accommodated in identical housings and in that the frequency of the auxiliary oscillator corresponds to the frequency of the quartz oscillator.

2. An arrangement as claimed in Claim 1, characterized in that the oven case (3) comprises heating elements (9,10) which are equidistant from the two chambers (5,6).

3. An arrangement as claimed in Claim 1 or 2, characterized in that the oven case (3) comprises a cover (4) which is constructed as a conduction plate and which accommodates electrical connection tracks (7) and the heating elements (9,10).

4. An arrangement as claimed in any one of Claims 1 to 3, characterized in that the electrical connection tracks (7) are made of a material having a low thermal conductivity and are centrally arranged in the oven case.

5. An arrangement as claimed in any one of Claims 1 to 4, characterized in that the oven case (3) has an insulating sheath.

6. An arrangement as claimed in any one of Claims 1 to 5, characterized in that the oven case (3) is made of aluminium.

## Revendications

1. Dispositif pour un oscillateur à quartz comportant un premier quartz (1) disposé dans un boîtier de thermostat (3), un deuxième quartz (2) d'un oscillateur auxiliaire (2) étant disposé dans le boîtier de thermostat (3), caractérisé en ce que le boîtier de thermostat (3) est conçu symétriquement et qu'il présente deux chambres (5, 6) pour recevoir les quartz (1, 2) de l'oscillateur à quartz (1) et de l'oscillateur auxiliaire (2), en ce que les quartz (1, 2) de l'oscillateur à quartz et de l'oscillateur auxiliaire sont chacun munis d'un boîtier de quartz identique et que la fréquence de l'oscillateur auxiliaire correspond à celle de l'oscillateur à quartz.

2. Dispositif selon la revendication 1, caractérisé en ce que le boîtier de thermostat (3) présente des éléments de chauffage (9, 10) disposés de façon équidistante par rapport aux deux chambres (5, 6).

3. Dispositif selon l'une des revendications 1 ou 2, caractérisé en ce que le boîtier de thermostat (3) présente un couvercle (4) conçu comme platine pour recevoir des connexions électriques (7) et les éléments de chauffage (9, 10).

4. Dispositif selon l'une des revendications 1 à 3, caractérisé en ce que les connexions électriques (7) sont réalisées à partir d'un matériau présentant une faible conductivité thermique et qu'elles sont disposées au milieu du boîtier de thermostat.

5. Dispositif selon l'une des revendications 1 à 4, caractérisé en ce que le boîtier de thermostat (3) présente une enveloppe isolante.

6. Dispositif selon l'une des revendications 1 à 5, caractérisé en ce que le boîtier de thermostat (3) est en aluminium.
